Europäisches Patentamt

**European Patent Office**

Office européen des brevets

(11) Veröffentlichungsnummer: **0 072 943**
A2

## (12) EUROPÄISCHE PATENTANMELDUNG

(21) Anmeldenummer: **82107072.9**

(22) Anmeldetag: **05.08.82**

(51) Int. Cl.³: **H 03 J 5/02**
**H 03 J 7/18**

(30) Priorität: **20.08.81 DE 3132943**

(43) Veröffentlichungstag der Anmeldung:
**02.03.83 Patentblatt 83/9**

(84) Benannte Vertragsstaaten:
**AT BE CH DE FR GB IT LI LU NL SE**

(71) Anmelder: **Licentia Patent-Verwaltungs-GmbH**
**Theodor-Stern-Kai 1**
**D-6000 Frankfurt/Main 70(DE)**

(72) Erfinder: **Henze, Werner, Ing.-grad.**
**Harzer Weg 5**
**D-3051 Hohnhorst(DE)**

(74) Vertreter: **Einsel, Robert, Dipl.-Ing.**
**Theodor-Stern-Kai 1**
**D-6000 Frankfurt/Main 70(DE)**

(54) Abstimmsystem für Hochfrequenzempfangsgeräte.

(57) Bei einem Abstimmsystem für Hochfrequenzempfangsgeräte erfolgt eine Standortbestimmung erfindungsgemäß
bei Sendern, die Kenndaten ausstrahlen, durch Auswertung
der Kenndaten, bei Sendern, die keine Kenndaten ausstrahlen, durch Vergleich der empfangenen Sender mit einer in
einem Speicher abgespeicherten Tabelle der empfangbaren
Sender, wobei die Auswertung der Kenndaten Priorität
genießt.

./...

Croydon Printing Company Ltd.

Fig.1

H 81/16     H 0072943

Licentia Patent-Verwaltungs-GmbH
Theodor-Stern-Kai 1

6000 Frankfurt/Main 70

Hannover, den 11.08.1981
Z13 PTL-Me/gn

## Abstimmsystem für Hochfrequenzempfangsgeräte

Die Erfindung betrifft ein Abstimmsystem für Hochfrequenzempfangsgeräte, insbesondere Rundfunk- oder Fernsehempfänger,
nach dem Oberbegriff des Patentanspruchs 1.

Es wurde bereits vorgeschlagen, Empfänger mit einem Datenspeicher zu versehen, in dem Abstimmdaten von in einem Gebiet empfangbaren Sendern gespeichert sind, wodurch die in
diesem Bereich empfangbaren Sender festgestellt werden und
aus der Verteilung der empfangbaren Sender auf den Standort
des Empfängers geschlossen wird, so daß mit Hilfe von diesem
Standort zugeordneten Daten eine Standortinformation abgeleitet und gespeichert wird (P 30 40 465.0). Auf diese
Weise können die Frequenzen der empfangbaren Sender eines
bestimmten Gebietes zur Anzeige gebracht werden und andererseits gewünschte Sender ohne Kenntnis und Einstellung der
Sendefrequenzen ausgewählt werden.

Es ist auch bekannt, von den Sendern ausgestrahlte Informationen mit zusätzlichen Kenndaten zu versehen, die den
Standort, das Programm, den Namen der Sendeanstalt, die
Programmart oder ähnliches angeben. Mit Hilfe dieses Ver-

BAD ORIGINAL

fahrens können ebenfalls gewünschte Sender ohne Kenntnis
der Sendefrequenzen abgefragt werden.

Das zuletzt genannte Verfahren ist in der Praxis bisher nicht
eingeführt, eine generelle Einführung gleichzeitig in
mehreren Ländern ist unwahrscheinlich. Das Verfahren hat
den Nachteil, daß eine Vorwahl, z.B. zum vorprogrammierten
Schalten des Empfängers auf einen bestimmten Sender nicht
möglich ist, wenn der jeweilige, ein Kennsignal ausstrahlende Sender zum Einstellzeitpunkt Sendepause hat.

Es ist Aufgabe der Erfindung, Anzeigefehler bei Sendern, die
keine Kenndaten ausstrahlen, zu vermeiden.

Die Aufgabe wird durch die im Anspruch 1 angegebene Erfindung
gelöst. Weitergehende Merkmale der Erfindung sind in den
Unteransprüchen beschrieben.

Solange nicht alle Sender in einem bestimmten Empfangsgebiet
Sendekenndaten aussenden, können durch die Erfindung auch
Sender erkannt und angezeigt werden, bzw. Sender eingestellt werden, die keine Kenndaten ausstrahlen. Die Kenntnis
der Sendefrequenz ist nicht erforderlich.

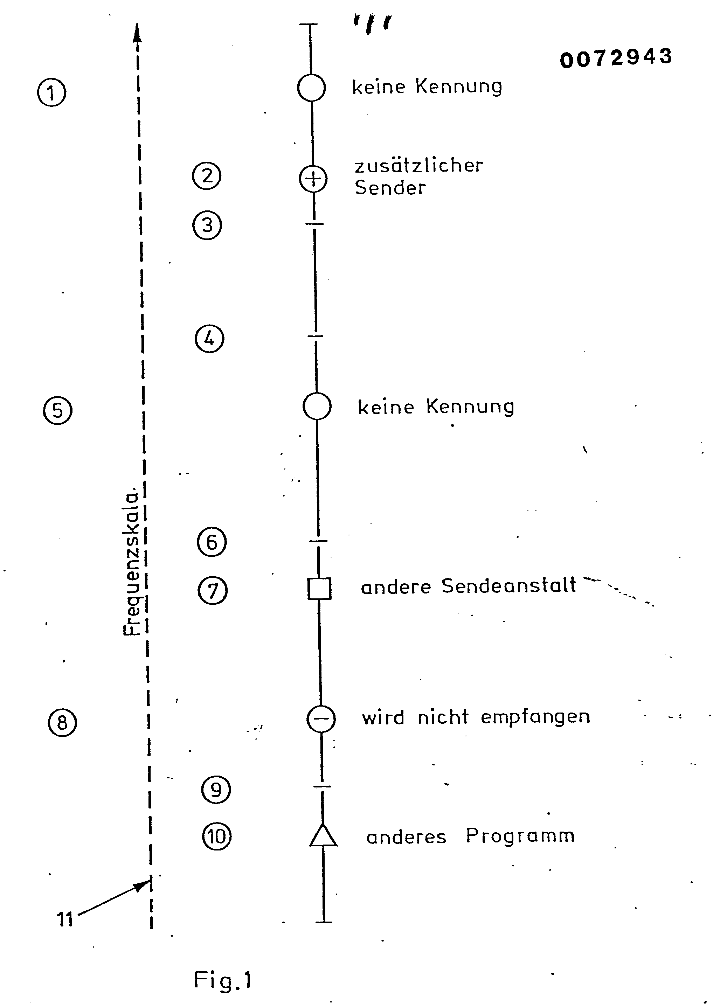

Die Erfindung wird anhand der Zeichnung nachstehend näher
erläutert.

Die Figur zeigt verschiedene Sender 1 - 10 auf einer Frequenzskala 11, die gleichzeitig empfangen werden können.
Die Sender 1, 5 und 8 können mit Hilfe des bereits vorgeschlagenen Verfahrens zur selbsttätigen Abstimmung erkannt werden. Diese Sender werden durch einen Suchlauf über
die gesamte Frequenzskala ermittelt. Die eindeutige Zuordnung der gefundenen Empfangsfrequenzen zu den Sendern
kann durch Vergleich der empfangenen Frequenzen mit einer
Tabelle, die z.B. in einem ROM (Read Only Memory) im Empfänger abgespeichert ist, vorgenommen werden. In diesem ROM sind sämtliche in einem Land, z.B. in der Bundesrepublik
Deutschland, empfangbaren Sender mit Sendedaten abgespeichert.

Die Sender 3, 4, 6 und 9 sollen Kenndaten ausstrahlen. Hierdurch ist eine eindeutige Zuordnung von Empfangsfrequenzen
zum Sender gegeben. Die Kenndaten können auf einer Anzeigeeinheit des Empfängers zur Anzeige gebracht werden.
Als Daten können z.B. die Programmart, das Programm, die
Sendefrequenz, der Name des Senders oder ähnliches angezeigt werden. Durch Vorwahl (z.B. Programm) eines Senders
auf einer Tastatur kann gezielt ein bestimmter Sender ausgewählt werden, ohne daß die Empfangsfrequenz bekannt ist.

Neben den Sendern, die eine Senderkennung ausstrahlen, und
den Sendern, die im Speicher abgespeichert sind, können
ggf. zusätzliche Sender empfangen werden, deren Frequenz
sich entweder geändert hat oder die aus einem anderen Land
herüberstrahlen. Es ist daher wünschenswert, in einem ROM
auch diejenigen Sender zu erfassen, die aus Nachbarländern
in den Empfangsbereich hineinstrahlen können.

Beim Einschalten des Empfängers muß der Empfänger zunächst
das Frequenzband einmal ganz automatisch durchfahren und
dabei die empfangenen Frequenzen mit den jeweils gemessenen
Feldstärken und evtl. gesendeten Senderkenndaten abspeichern, um eine selbsttätige Standortbestimmung vornehmen
zu können oder eine schnelle Senderumschaltung bei Sendern
mit Senderkenndaten zu ermöglichen. Nach dem Suchlauf
stehen die Empfangsfrequenzen mit den zugehörigen Senderkenndaten (Sendeanstalt und Programm) zur Verfügung, die
entweder dem ROM oder einem beim Suchlauf gefüllten RAM-
Speicher (Random Access Memory) entnommen werden können.
Bei Sendern, die gleichzeitig im ROM gespeichert sind und
die ebenfalls eine Senderkennung ausstrahlen, ist es vorteilhaft, der Senderkennung die Priorität zukommen zu lassen.
Eine Änderung in den Senderkenndaten, z.B. eine Programmänderung, würde dann sofort ausgewertet werden können, hingegen müßte bei einer selbsttätigen Standortbestimmung
das ROM ausgetauscht werden.

## Patentansprüche

1. Abstimmsystem für Hochfrequenzempfangsgeräte, insbesondere für Rundfunk- oder Fernsehgeräte, mit einem Datenspeicher (ROM), in dem Daten, insbesondere Abstimmdaten, von in einem Gebiet empfangbaren Sendern gespeichert sind, wobei an einem Standort in einem Unterbereich des Gebietes nur ein Teil der gespeicherten Sender mit ausreichender Feldstärke empfangbar ist, und in einem besonderen Betriebszustand des Empfängers, der der Initialisierung des Empfängers dient, die in einem Empfangsbereich (UKW) empfangbaren Sender festgestellt werden, dadurch gekennzeichnet, daß durch Zuordnung der empfangenen Sender zu den in diesem Gebiet möglichen Sendern eine Standortinformation abgeleitet und gespeichert wird, und daß bei denjenigen Sendern (3, 4, 6) die eine Kenninformation ausstrahlen, aus der Kenninformation die Standortinformation abgeleitet, gespeichert und ausgewertet wird.

2. System nach Anspruch 1, dadurch gekennzeichnet, daß eine Standortbestimmung durch Vergleich nur bei denjenigen Sendern vorgenommen wird, die keine Kenndaten ausstrahlen.

3. Schaltung nach Anspruch 1, dadurch gekennzeichnet, daß die Standortinformation zur Anzeige gebracht wird.

4. Schaltung nach Anspruch 1, dadurch gekennzeichnet, daß die Art der Standortbestimmung zur Anzeige gebracht wird.

5. Schaltung nach Anspruch 1, dadurch gekennzeichnet, daß die Standortbestimmung abschaltbar ausgeführt ist.

6. Schaltung nach Anspruch 1, dadurch gekennzeichnet, daß empfangene Senderkenndaten vorrangig vor den im Datenspeicher (ROM) des Empfängers gespeicherten Daten

- 2 -

0072943

H 81/16

ausgewertet werden.

0072943

keine Kennung

zusätzlicher Sender

keine Kennung

andere Sendeanstalt

wird nicht empfangen

anderes Programm

Frequenzskala.

11

Fig.1

H 81/16